# EUROPEAN PATENT SPECIFICATION

(11) **EP 2 798 924 B1**
(45) Date of publication and mention of the grant of the patent: **12.12.2018**
(21) Application number: 12821001.0
(22) Date of filing: 27.12.2012
(51) Int. Cl.: B60R 16/03, H02G 5/06, H05K 7/14, H02M 7/00

(54) **FAILURE PROTECTION FOR A POWER DELIVERY SYSTEM**
AUSFALLSCHUTZ FÜR EIN KRAFTÜBERTRAGUNGSSYSTEM
PROTECTION CONTRE LA DÉFAILLANCE POUR SYSTÈME DE FOURNITURE D'ÉNERGIE

(30) Priority: 30.12.2011 US 201161582000 P
(43) Date of publication of application: 05.11.2014
(73) Proprietor: General Electric Company, Schenectady, NY 12345 (US)
(72) Inventor: WOLFF, Jeffrey, John, Lawrence Park, PA 16531 (US); KUTTENKULER, Jason, Daniel, Lawrence Park, PA 16531 (US); MARI CURBELO, Alvaro, Jorge, 85748 Garching b. Munchen (DE); YOUNG, Henry, Todd, Lawrence Park, PA 16531 (US)
(74) Representative: Illingworth-Law, William Illingworth
(86) International application number: PCT/US2012/071782
(87) International publication number: WO 2013/101910

(56) References cited:
- DE-U1-202006 004 221
- US-A- 6 160 696
- US-A1- 2009 250 799

## Description

### BACKGROUND

### Field

Embodiments of the invention relate to power electronics systems. Other embodiments relates to inverters and other power electronics systems for converting one voltage waveform to another, e.g., for driving a load.

### Discussion of art

Many vehicles utilize electric motors for propulsion purposes. For example, an off-highway vehicle may include an engine for generating electricity, one or more motors for generating tractive effort, and a power delivery system for converting the generated electricity into a form suitable for powering the one or more motors. (An off-highway vehicle is a vehicle that is not for use on roads designated for primary use by automobiles. Examples of off-highway vehicles include locomotives and other rail vehicles, marine vessels, mining haul trucks, other heavy mining or construction equipment, and the like.) Other vehicles, such as on-highway vehicles like automobiles and busses, may be similarly outfitted.

Power delivery systems typically include semiconductor power devices for converting electricity from one waveform to another, e.g., AC to DC (alternating current to direct current), DC to DC, AC to DC to AC, and the like. For example, power diodes may be arranged as a rectifier to convert AC to DC. Power transistors may be arranged as an inverter, and controllably switched by a controller, to convert DC to AC. In the event of a fault or failure of a semiconductor power device, failure material such as gases, debris, and plasma can escape and damage other components within the power delivery system. The failure material can cause the failure to cascade throughout the power delivery system. As a result, one failure within the power delivery system can cause failure the entire power delivery system.

Accordingly, it may be desirable to provide a power delivery system that differs from power delivery systems currently available.
US 2009/250799 relates to a power semiconductor module for energy distribution comprising at least one power semiconductor, connection terminals for connection of the power semiconductor module, and a housing. It is an object to provide a power semiconductor module which provides explosion protection such as arcs.
DE 20 2006 004221 relates to a frequency converter having a protection unit, dividing space within a housing into an immolating section and a protection section means for impeding the of a degrading effect of an explosion occurring in the immolating section spreading into the protection section.
US 6,160,696 relates to a method and apparatus which provide low inductance, sufficient cooling capacity and easy installation and maintenance of insulated gate bipolar transistors (IGBTs) in power regulators.

### BRIEF DESCRIPTION

The invention is defined in the independent claims. Various optional features of the invention are defined in the dependent claims.

An embodiment relates to a power delivery system (e.g., a system for converting one electrical power waveform to another in a vehicle). The power delivery system comprises a first bus bar, plural semiconductor power devices coupled to the first bus bar, and a first housing. (To differentiate between the different semiconductor power devices for purposes of the present description, the plural semiconductor power devices may be characterized as including a "first" semiconductor power device and one or more "second" semiconductor power devices.) The first housing is coupled to the first bus bar, and the first semiconductor power device is enclosed within the first housing. The first housing comprises a first outlet configured to direct failure material of the first semiconductor power device away from the one or more second semiconductor power devices. More specifically, during operation of the power delivery system, if the first semiconductor power device fails, failure material produced by the first semiconductor power device due to the failure is routed out through the first outlet and away from the one or more second semiconductor power devices. Thus, according to one aspect of the invention, the failure of one device does not result in a cascade failure of other devices due to interaction between failure material and the other devices.

Another embodiment relates to a power delivery system comprising a first bus bar, a first semiconductor power device coupled to the first bus bar, and a second bus bar. The first bus bar comprises a first planar landing, a riser portion attached at a first edge of the riser portion to the first planar landing and angled at a non-zero degree angle with respect to the first planar landing, and a second planar landing attached to a second edge of the riser portion. (The second edge is parallel to the first edge.) The second planar landing is angled at the non-zero degree angle such that the second planar landing is parallel to the first planar landing. The second bus bar is attached to the second planar landing of the first bus bar and is parallel to the first planar landing. Thus, the second bus bar and the first bus bar define a space there between. In embodiments, the space accommodates fasteners used to connect semiconductor power devices to the first bus bar and/or the second bus bar, thereby providing a more compact multi-bus bar power delivery system than previous systems. Additionally, the first bus bar in effect places the first semiconductor power device above the plane of the second bus bar, which facilitates routing of failure material away from other components of the power delivery system. That is, since the failure material is ejected spaced apart from the second bus bar, it is believed to be less prone to traveling upwards or in other directions due to interaction with the second bus bar.

In another embodiment of the power delivery system with two bus bars as described immediately above, the power delivery system further comprises a first housing coupled to the first bus bar, with the first semiconductor power device being enclosed within the first housing. The first housing may comprise an outlet as described above for routing failure material of the first semiconductor power device away from other semiconductor power devices of the power delivery system.

Another embodiment relates to a power delivery system comprising plural first bus bars and a second bus bar. The first bus bars comprise respective first planar landings, riser portions attached at a first edge of the riser portions to the first planar landings and angled at a non-zero degree angle with respect to the first planar landings, and second planar landings attached to a second edge of the riser portions. The second edge is parallel to the first edge. The second planar landings are angled at the non-zero degree angle such that the second planar landings are parallel to the first planar landings. The plural first bus bars are attached to the second bus bar by way of a connection of the second planar landings of the first bus bars to the second bus bar, such that the first planar landings of the first bus bars are parallel to and offset from the second bus bar. The power delivery system further comprises plural semiconductor power devices respectively coupled to the first planar landings of the first bus bars.

### DRAWINGS

These and other features, aspects, and advantages of the invention will become better understood when the following detailed description is read with reference to the accompanying drawings in which like characters represent like parts throughout the drawings, wherein:
Fig. 1 is a block diagram of a diesel-electric locomotive in accordance with embodiments;
Fig. 2 is a block diagram of a power delivery system in accordance with embodiments;
Fig. 3 is a perspective view showing a portion of a power delivery system in accordance with embodiments;
Fig. 4 is a side elevation view showing part of a power delivery system in accordance with embodiments;
Figs. 5-6 are perspective views of power delivery systems, according to embodiments of the invention;
Fig. 7 is a schematic side elevation view showing a power delivery system in accordance with embodiments; and
Fig. 8 is a schematic side elevation view showing a portion of a power delivery system in accordance with embodiments, with dashed lines representing interior features.

### DETAILED DESCRIPTION

Embodiments of the invention relate to a power delivery system, such as a system for converting one electrical power waveform to another in a vehicle. The power delivery system comprises a first bus bar, plural semiconductor power devices coupled to the first bus bar, and a first housing. According to one aspect, the first housing comprises a first outlet configured to direct failure material of a first of the semiconductor power devices away from others of the semiconductor power devices. Thus, upon failure of one of the semiconductor power devices, damage to other semiconductor power devices in the power delivery system is reduced or eliminated.

According to another aspect, the power delivery system alternatively or additionally comprises a second bus bar connected to the first bus bar. The first bus bar and the second bus bar are configured to provide a compact multi-bus bar package, for use (for example) in vehicles and other locations with limited space. For example, in addition to a first planar landing for attachment and electrical connection of semiconductor power devices, the first bus bar may include a riser portion and a second planar landing to which the second bus bar is attached, for the second bus bar to lie parallel and generally opposed to the first bus bar. A space defined between the two bus bars accommodates fasteners, a cooling air flow, etc. As noted above, the structural configuration of the first bus bar results in the first semiconductor power device being positioned above and spaced apart from the plane of the second bus bar, which also facilitates routing of failure material away from other components of the power delivery system. That is, since the failure material is ejected spaced apart from the second bus bar, it is believed to be less prone to traveling upwards or in other unintended directions due to interaction with the second bus bar.

In any of the embodiments herein, the first bus bur and/or the second bus bar may be laminated bus bars. A laminated bus bar includes alternating positive and negative bus bar layers (e.g., generally planar copper layers), which are separated by relatively thin layers of dielectric insulation. Devices are connected to the layers by way of vias, through holes, interconnect layers or other interconnect features, appropriately configured fasteners, or the like. Bus bars may be generally planar (or at least include generally planar sections), and for many applications are relatively high capacity in terms of current/power load (e.g., capable of carrying tens to hundreds of amperes).

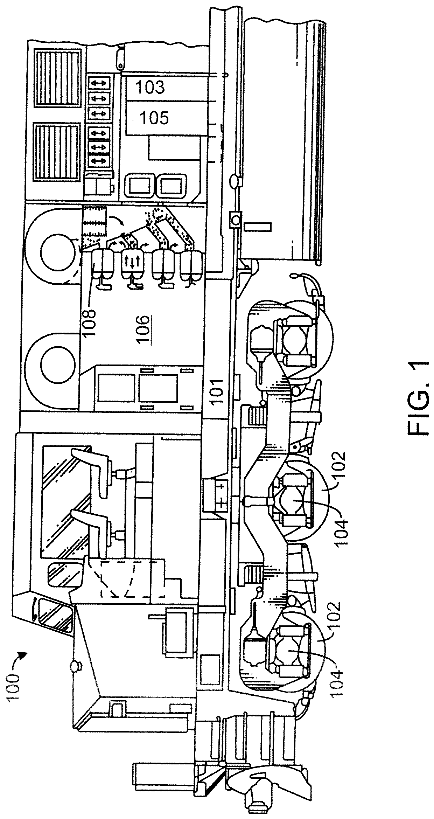

Turning now to the figures, Fig. 1 is a block diagram of a diesel-electric locomotive, provided as one example of a vehicle in which power delivery systems of the invention may be deployed. A rail vehicle is a vehicle configured to travel along a rail or similar fixed-route guideway. A consist is a group of plural rail vehicles that are linked together to travel along a route. A consist may include one or more powered rail vehicles (capable of self-propulsion) and one or more non-powered rail vehicles (incapable of self-propulsion). One example of a consist is a train, which includes one or more locomotives (powered rail vehicles) and one or more passenger or cargo cars (non-powered rail vehicles). Power delivery systems used in a locomotive or other powered rail vehicle may reside within the limits of the rail vehicle body. For ease of description, power delivery systems are described as residing within the confined space of a locomotive body or other off-highway vehicle. However, embodiments are applicable to vehicles generally.

Referring back to Fig. 1, the vehicle (e.g., locomotive), which is shown in a simplified, partial cross-sectional view, is generally referred to by the reference number 100. The vehicle 100 includes a vehicle platform 101, which comprises a structure (e.g., metal frame) for supporting other on-board components of the vehicle. The vehicle may additionally comprise an engine 103 (internal combustion engine) attached to the vehicle platform, and an alternator 105 coupled to the engine, which is operative to generate electricity when mechanically driven by an output shaft or other output of the engine. A plurality of traction motors, not visible in Fig. 1, are located behind drive wheels 102 and coupled in a driving relationship to axles 104. A plurality of auxiliary motors, not visible in Fig. 1, are located in various locations on the locomotive, and coupled with various auxiliary loads like blowers or radiator fans. The motors may be AC electric motors or DC electric motors. As explained in detail below, the locomotive 100 may include a power delivery system as described herein, e.g., a plurality of electrical inverter circuits for controlling electrical power to the motors. The electrical inverter circuits may include bus bars, and/or be interconnected with one another, using bus bars. For example, the bus bars may provide a conductive path for the DC voltage that feeds the various electrical components of the power delivery system that are coupled to the bus bar, such as semiconductor switches or other semiconductor power devices. The semiconductor power devices may be enclosed in one or more housings and connected to the bus bar in vertical stacks.

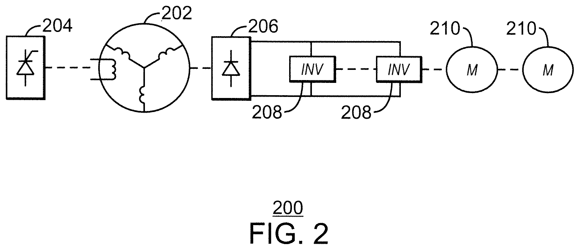

Fig. 2 is a block diagram of a power delivery system in accordance with embodiments. The power delivery system, which is generally referred to by the reference number 200, may be used to control AC power to a load, such as one or more motors, for a vehicle 100 such as the locomotive shown in Fig. 1. The power delivery system 200 may include an alternator 202 driven by an engine such as a diesel engine (not shown in this view, but see 103 in Fig. 1). The AC electrical power output of the alternator 202 is regulated by field excitation control indicated by a field control 204. The AC power from the alternator 202 is rectified to DC power by a rectifier 206, and coupled to one or more inverters or other power converters 208 ("INV"). The inverters or other power converters 208 may use power semiconductor devices (e.g., power semiconductor transistors, controlled as switches, and/or power diodes) to convert the DC power to AC power with variable frequency and variable voltage amplitude for application to one or more AC motors 210 ("M"). Alternatively, the power converters 208 may be configured to convert DC power at one level to DC power at another level, for application to one or more DC motors. Although two motors are shown, the vehicle may include only one motor, or more than two motors, e.g., a locomotive may include four to six AC electric motors, or four to six DC electric motors, each controlled, for example, by an individual inverter.

The power diodes, power transistors, and other semiconductor power devices are solid-state electronic devices that include one or more semiconductor materials arranged for use in a circuit (e.g., they include one or more internal semiconductor junctions and two or more terminals for functioning as diodes, switches, in an active region, or the like), and which have a substantially higher power capacity than low power/small signal electronic devices, e.g., rated operation of 5A - 1kA at 50V - 10 kV, versus operation in the millivolts/milliamps range. Examples of semiconductor power devices that may be employed in an inverter, other power converter, or other power delivery system include insulated gate bipolar transistors (IGBTs), reverse-conducting IGBTs, and bi-mode insulated gate transistors (BIGTs), among others.

Referring again to Fig. 1, the power delivery system may be at least partially located in an equipment compartment 106 of the vehicle 100. The control electronics for the inverters or other power converters 208 (Fig. 2) and the field control 204 (Fig. 2) as well as other electronic components may be disposed on laminated bus bars within the equipment compartment 106. Additionally, within the equipment compartment 106, the power delivery system (or portions thereof) may be mounted to air-cooled heat sinks 108.

As noted, the power delivery system (e.g., including inverters or other power converters) may include one or more semiconductor power devices. During a semiconductor power device fault, failure material from the semiconductor power device may cascade throughout the vertical stacks of components connected to a bus bar within the equipment compartment 106. (Due to the forces involved, the failure material is not limited necessarily to downward travel due to gravity; instead, the failure material may travel upwards, to the sides, etc.) In embodiments, to limit the damage to other components connected to the bus bar(s) within the equipment compartment 106, the semiconductor power devices are sealed into one or more housings connected to the bus bar(s) in a manner that directs any failure material away from any remaining components connected to the bus bar. For example, each of the one or more housings may include a respective outlet that directs failure material away from the other components. For example, if a power delivery system includes a first semiconductor power device in a housing and one or more second semiconductor power devices (either in that housing or in other housings), and the first semiconductor power device fails, failure material from the first semiconductor power device is directed away from the one or more second semiconductor power devices.

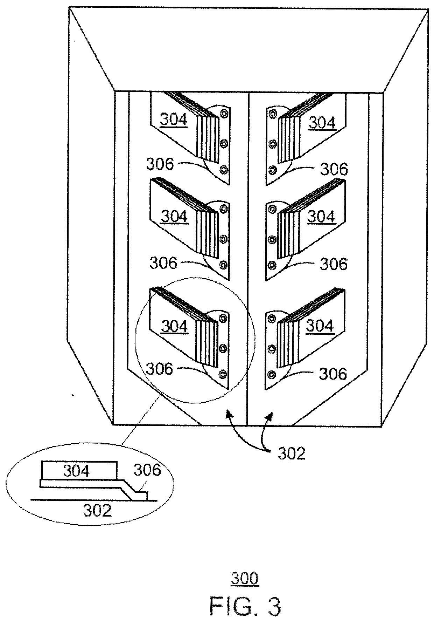

Fig. 3 is a diagram showing a portion of a power delivery system 300 in accordance with embodiments. The power delivery system 300 may be housed within the electrical compartment 106 of Fig. 1. The power delivery system 300 includes first bus bars 306, and a second bus bar 302. The bus bars may be laminated bus bars that provide conductive paths for the DC voltage that feeds the various electrical components of the power delivery system that are coupled to the bus bars 302, 306, such as the semiconductor power devices used in the inverters or other power converters 208 (Fig. 2) of the power delivery system. The electrical components coupled to the second bus bar 302 may be stacked vertically. Additionally, the semiconductor power devices may be enclosed in one or more housings 304 respectively connected to the first bus bars 306. There may be one housing for plural of the semiconductor power devices, or each semiconductor power device may have its own individual housing. Although not shown in the figures, the power delivery system may further comprise one or more of: one or more copper heat sinks or other heat sinks; a common capacitor bank; and/or various voltage sources and current carrying cables. The semiconductor power device(s) of the power delivery system may be operatively arranged in a circuit to receive an input first voltage from a voltage source through the bus bar 302, and to output an output second voltage for application to a load. For example, if the semiconductor power devices are plural power diodes arranged as a rectifier, the plural power diodes may be configured to receive an AC input voltage as the input first voltage, and to output a DC output voltage (e.g., to a DC bus) as the output second voltage. If the semiconductor power devices are plural power transistors arranged as an inverter or other power converter, the power transistors may be configured (for example) to receive a DC input voltage as the first input voltage, and to output an AC output voltage (one phase or three phase) as the output second voltage, for powering a motor. For an inverter or other power converter, the power delivery system may include a control module that is operably coupled to the semiconductor power devices and configured (in a known manner) to controllably switch the semiconductor power devices for converting the input voltage to the output voltage.

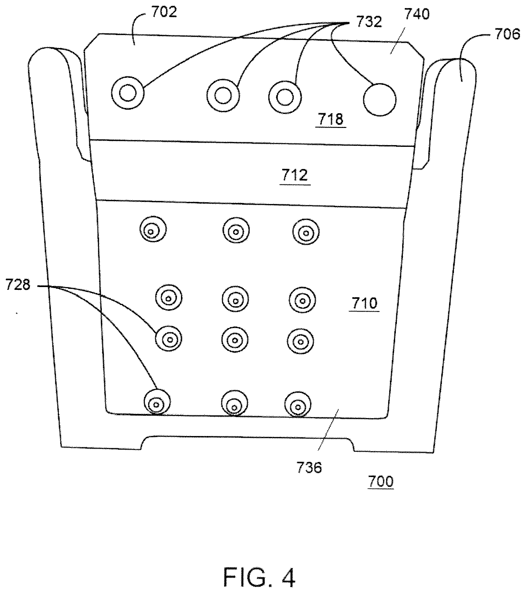

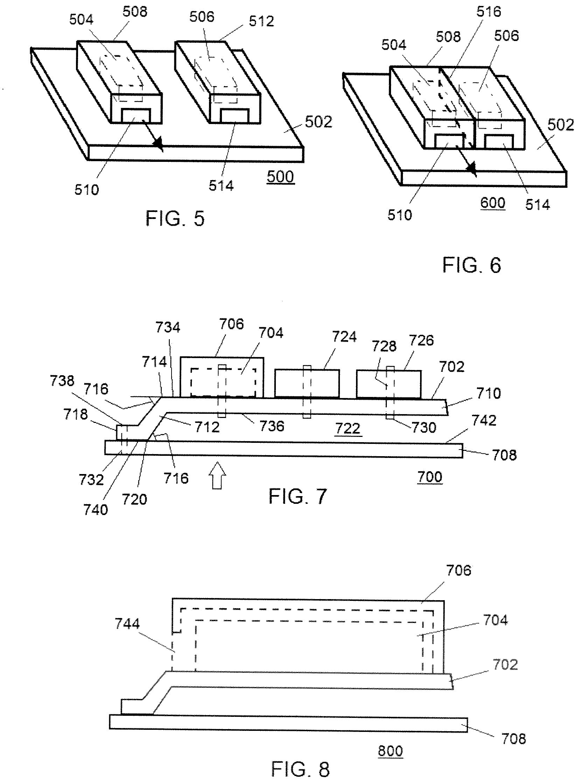

Turning now to Figs. 4-8, but first with reference to Fig. 5, an embodiment of a power delivery system 500 (e.g., a system for converting one electrical power waveform to another in a vehicle) comprises a first bus bar 502, plural semiconductor power devices 504, 506 coupled to the first bus bar, and a first housing 508. For example, the plural semiconductor power devices may include a first semiconductor power device 504 and a second semiconductor power device 506. The first housing 508 is coupled to the first bus bar 502, and the first semiconductor power device 504 is enclosed within the first housing 508. The first housing 508 comprises a first outlet 510 configured to direct failure material of the first semiconductor power device 504 away from the one or more second semiconductor power devices 506 (see the indicated arrow). More specifically, during operation of the power delivery system, if the first semiconductor power device fails, failure material produced by the first semiconductor power device due to the failure is routed out through the first outlet 510 and away from the one or more second semiconductor power devices 506. For example, if the direction of the indicated arrow is a downwards direction, then the outlet of the housing is facing downwards, for directing the failure material in that direction and preventing the failure material from traveling upwards, or to the side. As another example, if the direction of the indicated arrow is to the side, then the outlet of the housing is facing towards that side, for directing the failure material in that direction and preventing the failure material from traveling upwards, immediately downwards, to the other side, etc. Thus, according to one aspect of the invention, the failure of one device does not result in a cascade failure of other devices due to interaction between failure material and the other devices.

The outlet(s) 510 is configured to direct failure material away from other devices by virtue of the direction which it faces, and also by virtue (at least in some embodiments) of being the only outlet to the housing. That is, failure material will tend to travel the path of least resistance, which is defined by the outlet. (As should the appreciated, the semiconductor power devices may be thermally connected to the housings for heat management, and/or they may be connected to metal heat sinks for the same purpose.) It should also be appreciated that the first bus bar functions in combination with the housing outlet to route the failure material a particular direction. That is, the housing, housing outlet, and top surface of the bus bar in combination define a channel leading from the semiconductor power device to external the housing, for routing the failure material in a designated direction.

In another embodiment of the power delivery system, the power delivery system further comprises one or more second housings 512 coupled to the first bus bar 502. The one or more second semiconductor power devices 506 are housed in the one or more second housings 512. For example, there may be plural second semiconductor power devices individually housed in respective plural second housings, or plural semiconductor power devices housed in one second housing, or combinations thereof. In Fig. 5, one second semiconductor power device 506 is shown housed in the one second housing 512, as an example. The one or more second housings 512 may have respective outlets 514 (one is shown in Fig. 5) that are configured to direct failure material away from other semiconductor power devices and/or other components of the power delivery system.

Fig. 6 shows another embodiment of a power delivery system 600, comprising the first housing 508 that is configured to house the first semiconductor power device 504 and the second semiconductor power device 506 (additional semiconductor power devices could be housed in a similar manner). The two semiconductor power devices 504, 506 are contained in separate compartments, each with an associated outlet 510, 514, with the compartments being defined by an internal rib or wall 516 of the housing 508. In other embodiments, plural semiconductor power devices are housed in the same space/compartment. In such embodiments, the semiconductor power devices of the same space/compartment are not protected from failure material of one another, but instead, the outlet(s) of the housing direct the failure material of any of the semiconductor power devices of the housing away from other components of the power delivery system.

In any of the embodiments herein, the housings 304, 508, 512, etc. may be made of a fiberglass-reinforced thermoset polyester (e.g., Glastic brand) or other relatively high strength, high melting point polymer. The outlets may be formed as part of a molding process of the polymer, or they may be formed using a machining operation or the like.

With reference to Fig. 7, another embodiment relates to a power delivery system 700 comprising a first bus bar 702 (e.g., a first laminated bus bar), a first semiconductor power device 704 coupled to the first bus bar, and a second bus bar 708 (e.g., a second laminated bus bar). The first bus bar 702 comprises a first planar landing 710, a riser portion 712 attached at a first edge 714 of the riser portion to the first planar landing and angled at a non-zero degree angle 716 (e.g., in one embodiment, from forty-five degrees to sixty degrees, and in another embodiment, from forty-five degrees to ninety degrees) with respect to the first planar landing, and a second planar landing 718 attached to a second edge 720 of the riser portion. (The second edge is parallel to the first edge.) The second planar landing 718 is angled at the non-zero degree angle 716 such that the second planar landing is parallel to the first planar landing. The second bus bar 708 is attached to the second planar landing of the first bus bar and is parallel to the first planar landing. Thus, the second bus bar and the first bus bar define a space 722 there between. The configuration of Fig. 7 provides for improved cooling as between the two bus bars, and has a more compact footprint, for realizing a configuration with plural bus bars, than other systems with plural bus bars. For example, in the embodiment of Fig. 7, the second bus bar 708 may be a vertically oriented bus bar for interconnecting the power delivery system with other components, e.g., of a larger power delivery system. (That is, the embodiment of Fig. 7 may be a sub-system of a larger system, such as one inverter or other power converter in a system that includes plural power converters at least some of which are interconnected by the second bus bar 708.)

As shown in Fig. 7, the power delivery system 700 may further comprise one or more second semiconductor power devices 724, 726, which may be housed in one or more second housings (not shown), or in the first housing. The semiconductor power devices may be connected to the first bus bar 702 by way of fasteners 728. The space 722 defined by the two bus bars accommodates portions 730 of the fasteners (e.g., bolt heads, nuts and washers, or the like). The first bus bar 702 and the second bus bar 708 may be connected by one or more fasteners 732.

In another embodiment of the power delivery system 700, the first planar landing 710 of the first bus bar 702 has a flat first top side 734 and a flat first bottom side 736 opposite the first top side. The second planar landing 718 has a flat second top side 738 and a flat second bottom side 740 opposite the second top side. The second bus bar 708 is attached to the second bottom side 740 of the second planar landing 718 of the first bus bar 702. A top surface 742 of the second bus bar and the first bottom side 736 of the first bus bar define the space 722 between the second bus bar and the first bus bar. The first semiconductor power device 704 is attached to the first top side 734 of the first bus bar. (Other semiconductor power devices, if present, may be also attached to the first top side.)

Fig. 4 is a view of the power delivery system 700 from the perspective of the arrow in Fig. 7, but with the second bus bar 708 removed. Thus, Fig. 4 shows the first bus bar 702, and in particular the first landing 710, riser portion 712, and second landing portion 718, from the bottom.

With reference to Fig. 8, another embodiment of a power delivery system 800 is generally similar to the system 700 of Fig. 7. The system 800 further comprises a first housing 706 coupled to the first bus bar 702, with the first semiconductor power device 704 being enclosed within the first housing 706. The first housing 706 comprises an outlet 744 as described above for routing failure material of the first semiconductor power device 704 away from other semiconductor power devices of the power delivery system. In other embodiments, the power delivery system 800 includes features such as shown and described in reference to Figs. 5-6.

As should be appreciated, with reference to Fig. 3 and Fig. 7, the first bus bar 702 and the second bus bar 708 of Fig. 7 may correspond to the first bus bars 306 and second bus bar 302 of Fig. 3. That is, each of the first bus bars 306 in Fig. 3 may be configured like the first bus bar 702 of Fig. 7. (See the inset detail of Fig. 3.) The second bus bar 302 may be planar, or it may be L-shaped in lateral cross section. The second bus bar 302 may be vertically oriented. Additionally, although a particular orientation of the first bus bars 306 is shown in Fig. 3, other orientations are possible. Still further, the first bus bars 306 may have configurations other than those shown in Fig. 3.

An embodiment relates to a power delivery system (e.g., a system for converting one electrical power waveform to another in a vehicle). The power delivery system comprises a first bus bar, plural semiconductor power devices coupled to the first bus bar, and a first housing. (To differentiate between the different semiconductor power devices for purposes of the present description, the plural semiconductor power devices may be characterized as including a "first" semiconductor power device and one or more "second" semiconductor power devices.) The first housing is coupled to the first bus bar, and the first semiconductor power device is enclosed within the first housing. The first housing comprises a first outlet configured to direct failure material of the first semiconductor power device away from the one or more second semiconductor power devices.

In another embodiment of the power delivery system, the first semiconductor power device comprises an insulated gate bipolar transistor.

In another embodiment of the power delivery system, the one or more second semiconductor power devices are enclosed within the first housing.

In another embodiment of the power delivery system, the system further comprises one or more second housings coupled to the first bus bar. The one or more second semiconductor power devices are housed in the one or more second housings.

In another embodiment of the power delivery system, the power delivery system comprises plural of the second semiconductor power devices and plural of the second housings. The second semiconductor power devices are respectively individually housed in the second housings.

In another embodiment of the power delivery system, each of the one or more second housings comprises a respective second outlet configured to direct failure material away from the first semiconductor power device and away from others of the one or more second housings.

In another embodiment of the power delivery system, the first housing and/or the one or more second housings comprise a fiberglass-reinforced polyester material.

In another embodiment of the power delivery system, the first bus bar comprises a first planar landing having a flat first top side and a flat first bottom side opposite the first top side, a riser portion attached at a first edge of the riser portion to the first planar landing and angled at a non-zero degree angle with respect to the first planar landing, and a second planar landing having a flat second top side and a flat second bottom side opposite the second top side. The second planar landing is attached to a second edge of the riser portion. The second edge is parallel to the first edge. The second planar landing is angled at the non-zero degree angle such that the second planar landing is parallel to the first planar landing. The power delivery system further comprises a second bus bar attached to the second bottom side of the second planar landing of the first bus bar and parallel to the first planar landing. A top surface of the second bus bar and the first bottom side of the first bus bar define a space between the second bus bar and the first bus bar. The first semiconductor power device, the first housing, and the one or more second semiconductor power devices are attached to the first top side of the first bus bar.

In another embodiment of the power delivery system, the first semiconductor power device and the one or more second semiconductor power devices are attached to the first bus bar by respective fasteners. Portions of the fasteners extend past the bottom surface of the first bus bar into the space that is defined between the second bus bar and the first bus bar.

Another embodiment relates to a power delivery system comprising a first bus bar, a first semiconductor power device coupled to the first bus bar, and a second bus bar. The first bus bar comprises a first planar landing, a riser portion attached at a first edge of the riser portion to the first planar landing and angled at a non-zero degree angle with respect to the first planar landing, and a second planar landing attached to a second edge of the riser portion. (The second edge is parallel to the first edge.) The second planar landing is angled at the non-zero degree angle such that the second planar landing is parallel to the first planar landing. The second bus bar is attached to the second planar landing of the first bus bar and is parallel to the first planar landing.

In another embodiment of the power delivery system with two bus bars as described immediately above, the power delivery system further comprises a first housing coupled to the first bus bar, with the first semiconductor power device being enclosed within the first housing. The first housing may comprise an outlet as described above for routing failure material of the first semiconductor power device away from other semiconductor power devices of the power delivery system. For example, in one embodiment of the power delivery system, the power delivery system further comprises one or more second semiconductor power devices coupled to the first bus bar. The first housing comprises a first outlet configured to direct failure material of the first semiconductor power device away from the one or more second semiconductor power devices. The first housing may comprise a fiberglass-reinforced polyester material.

In another embodiment of the power delivery system, the first planar landing of the first bus bar has a flat first top side and a flat first bottom side opposite the first top side. The second planar landing has a flat second top side and a flat second bottom side opposite the second top side. The second bus bar is attached to the second bottom side of the second planar landing of the first bus bar. A top surface of the second bus bar and the first bottom side of the first bus bar define the space between the second bus bar and the first bus bar. The first semiconductor power device is attached to the first top side of the first bus bar.

Another embodiment relates to a vehicle. The vehicle comprises a vehicle platform, an engine attached to the platform, an alternator attached to the engine (the alternator is configured to generate electricity when mechanically driven by the engine), a motor attached to the vehicle platform, and a power delivery system (e.g., power converter) as described herein. The power converter is configured to convert the electricity for powering the motor. For example, the power delivery system may comprise one or more housings as set forth herein, and/or first and second bus bars as set forth herein.

Another embodiment relates to a power delivery system comprising plural first bus bars and a second bus bar. The first bus bars comprise respective first planar landings, riser portions attached at a first edge of the riser portions to the first planar landings and angled at a non-zero degree angle with respect to the first planar landings, and second planar landings attached to a second edge of the riser portions. The second edge is parallel to the first edge. The second planar landings are angled at the non-zero degree angle such that the second planar landings are parallel to the first planar landings. The plural first bus bars are attached to the second bus bar by way of a connection of the second planar landings of the first bus bars to the second bus bar, such that the first planar landings of the first bus bars are parallel to and offset from the second bus bar. The power delivery system further comprises plural semiconductor power devices respectively coupled to the first planar landings of the first bus bars. In another embodiment, the power delivery system further comprises plural housings respectively coupled to the first planar landings of the first bus bars. The plural semiconductor power devices are respectively housed in the plural housings, and the plural housings comprise respective outlets configured to direct failure material of the semiconductor power devices away from one another. The first bus bars may be arrayed along the second bus bar with a major axis of the first bus bars (left to right from the perspective of the detail portion of Fig. 3) perpendicular to a major axis of the second bus bar (up and down in the perspective of Fig. 3).

It is to be understood that the above description is intended to be illustrative, and not restrictive. For example, the above-described embodiments (and/or aspects thereof) may be used in combination with each other. In addition, many modifications may be made to adapt a particular situation or material to the teachings of the invention without departing from its scope. While the dimensions and types of materials described herein are intended to illustrate embodiments of the invention, they are by no means limiting and are exemplary in nature. Other embodiments may be apparent upon reviewing the above description. The scope of the invention should, therefore, be determined with reference to the appended claims, along with the full scope of equivalents to which such claims are entitled.

In the appended claims, the terms "including" and "in which" are used as the plain-English equivalents of the respective terms "comprising" and "wherein." Moreover, in the following claims, the terms "first," "second," "third," "upper," "lower," "bottom," "top," "up," "down," etc. are used merely as labels, and are not intended to impose numerical or positional requirements on their objects. Further, the limitations of the following claims are not written in means-plus-function format and are not intended to be interpreted based on 35 U.S.C. § 112, sixth paragraph, unless and until such claim limitations expressly use the phrase "means for" followed by a statement of function void of further structure.

As used herein, an element or step recited in the singular and proceeded with the word "a" or "an" should be understood as not excluding plural of said elements or steps, unless such exclusion is explicitly stated. Furthermore, references to "one embodiment" of the invention are not intended to be interpreted as excluding the existence of additional embodiments that also incorporate the recited features. Moreover, unless explicitly stated to the contrary, embodiments "comprising," "including," or "having" an element or a plurality of elements having a particular property may include additional such elements not having that property.

Since certain changes may be made in the above-described power delivery system, without departing from the scope of the invention herein involved, it is intended that all of the subject matter of the above description or shown in the accompanying drawings shall be interpreted merely as examples illustrating the inventive concept herein and shall not be construed as limiting the invention.

## Claims

1. A power delivery system **characterized in that** it comprises:
a first bus bar (306, 502, 702);
a first semiconductor power device (504, 704) coupled to the first bus bar;
one or more second semiconductor power devices (306, 506, 706) coupled to the first bus bar; and
a first housing coupled (304, 508, 512, 706) to the first bus bar, wherein the first semiconductor power device is enclosed within the first housing;
wherein the first housing comprises a first outlet (510, 514, 744) configured to direct failure material of the first semiconductor power device away from the one or more second semiconductor power devices;
wherein the first bus bar functions in combination with the first outlet in the first housing to route the failure material in a particular direction which is away from the one or more second semiconductor power devices.

2. The power delivery system of claim 1, wherein the first semiconductor power device comprises an insulated gate bipolar transistor.

3. The power delivery system of claim 1 or claim 2, wherein the one or more second semiconductor power devices (306, 506, 706) are enclosed within the first housing (304, 508, 512, 706).

4. The power delivery system of any of claims 1 to 3, further comprising one or more second housings (512) coupled to the first bus bar, wherein the one or more second semiconductor power devices are housed in the one or more second housings.

5. The power delivery system of claim 4, comprising a plurality of the second semiconductor power devices and a plurality of the second housings, wherein the second semiconductor power devices are respectively individually housed in the second housings.

6. The power delivery system of claim 4 or claim 5, wherein each of the one or more second housings comprises a respective second outlet configured to direct failure material away from the first semiconductor power device and away from others of the one or more second housings.

7. The power delivery system of any preceding claim, wherein the first housing and the one or more second housings comprise a fiberglass-reinforced polyester material.

8. The power delivery system of any preceding claim, wherein:
the first bus bar comprises a first planar landing having a flat first top side and a flat first bottom side opposite the first top side, a riser portion attached at a first edge of the riser portion to the first planar landing and angled at a non-zero degree angle with respect to the first planar landing, and a second planar landing having a flat second top side and a flat second bottom side opposite the second top side, the second planar landing attached to a second edge of the riser portion, the second edge parallel to the first edge, and the second planar landing angled at the non-zero degree angle such that the second planar landing is parallel to the first planar landing;
the power delivery system further comprises a second bus bar attached to the second bottom side of the second planar landing of the first bus bar and parallel to the first planar landing, wherein a top surface of the second bus bar and the first bottom side of the first bus bar define a space between the second bus bar and the first bus bar; and
the first semiconductor power device, the first housing, and the one or more second semiconductor power devices are attached to the first top side of the first bus bar.

9. The power delivery system of claim 8, wherein the first semiconductor power device and the one or more second semiconductor power devices are attached to the first bus bar by respective fasteners, wherein portions of the fasteners extend past the bottom surface of the first bus bar into the space that is defined between the second bus bar and the first bus bar.

10. The power delivery system of any preceding claim, wherein the first housing, the first outlet, and a top surface of the first bus bar to which the first semiconductor power device is coupled together define a channel extending from the first semiconductor power device to external the housing, for routing the failure material from the first semiconductor power device to external the housing and away from the one or more second semiconductor power devices.

11. A vehicle comprising:
a vehicle platform;
an engine attached to the platform;
an alternator attached to the engine, the alternator configured to generate electricity when mechanically driven by the engine;
a motor attached to the vehicle platform; and
a power converter comprising the power delivery system of any preceding claim, wherein the power converter is configured to convert the electricity for powering the motor.

## Patentansprüche

1. Stromversorgungssystem, **dadurch gekennzeichnet, dass** es umfasst:
eine erste Stromschiene (306, 502, 702);
eine erste Leistungshalbleitervorrichtung (504, 704), welcher an die erste Stromschiene gekoppelt ist;
eine oder mehrere zweite Leistungshalbleitervorrichtungen (306, 506, 706), welche an die erste Stromschiene gekoppelt sind; und
ein erstes Gehäuse, welches an die erste Stromschiene gekoppelt (304, 508, 512, 706) ist, wobei die erste Leistungshalbleitervorrichtung von dem ersten Gehäuse umschlossen ist;
wobei das erste Gehäuse einen ersten Auslass (510, 514, 744) umfasst, welcher konfiguriert ist, Fehlermaterial der ersten Leistungshalbleitervorrichtung weg von der einen oder den mehreren zweiten Leistungshalbleitervorrichtungen zu leiten;
wobei die erste Stromschiene in Kombination mit dem ersten Auslass in dem ersten Gehäuse funktioniert, um das Fehlermaterial in einer bestimmten Richtung zu leiten, welche weg von der einen oder den mehreren zweiten Leistungshalbleitervorrichtungen ist.

2. Stromversorgungssystem nach Anspruch 1, wobei die erste Leistungshalbleitervorrichtung einen Bipolartransistor mit isolierter Gate-Elektrode umfasst.

3. Stromversorgungssystem nach Anspruch 1 oder Anspruch 2, wobei die eine oder die mehreren zweiten Leistungshalbleitervorrichtungen (306, 506, 706) von den ersten Gehäuse (304, 508, 512, 706) umschlossen sind.

4. Stromversorgungssystem nach einem der Ansprüche 1 bis 3, weiter ein oder mehrere zweite Gehäuse (512) umfassend, welche an die erste Stromschiene gekoppelt sind, wobei die eine oder die mehreren zweiten Leistungshalbleitervorrichtungen von dem einen oder den mehreren Gehäusen umschlossen sind.

5. Stromversorgungssystem nach Anspruch 4, umfassend eine Vielzahl von den zweiten Leistungshalbleitervorrichtungen und eine Vielzahl von den zweiten Gehäusen, wobei die zweiten Leistungshalbleitervorrichtungen jeweils individuell in den zweiten Gehäusen untergebracht sind.

6. Stromversorgungssystem nach Anspruch 4 oder Anspruch 5, wobei jedes von dem einen oder den mehreren zweiten Gehäuses einen entsprechenden zweiten Auslass umfasst, welcher konfiguriert ist, um Fehlermaterial weg von der ersten Leistungshalbleitervorrichtung und weg von anderen von dem einen oder den mehreren zweiten Gehäusen zu leiten.

7. Stromversorgungssystem nach einem der vorstehenden Ansprüche, wobei das erste Gehäuse und das eine oder die mehreren zweiten Gehäuse ein glasfaserverstärktes Polyestermaterial umfassen.

8. Stromversorgungssystem nach einem der vorstehenden Ansprüche, wobei:
die erste Stromschiene ein erstes planares Podest mit einer ebenen ersten Oberseite und einer ebenen ersten Unterseite gegenüber der ersten Oberseite, einem Steigungsabschnitt, welcher an einem ersten Rand des Steigungsabschnitt an dem ersten ebenen Podest angebracht und in einem Nicht-Null-Winkel in Bezug auf das erste ebene Podest gewinkelt ist, und ein zweites planares Podest mit einer ebenen zweiten Oberseite und einer ebenen zweiten Unterseite gegenüber der zweiten Oberseite, wobei das zweite planare Podest an einem zweiten Rand des Steigungsabschnitts angebracht ist, der zweite Rand parallel zu dem ersten Rand ist, und das zweite planare Podest in dem Nicht-Null-Winkel gewinkelt ist, sodass das zweite planare Podest parallel zu dem ersten planaren Podest ist, umfasst;
das Stromversorgungssystem weiter eine zweite Stromschiene umfasst, welche an der zweiten Unterseite des zweiten planaren Podests der ersten Stromschiene und parallel zu dem ersten planaren Podest angebracht ist, wobei eine obere Fläche der zweiten Stromschiene und die erste Unterseite der ersten Stromschiene einen Abstand zwischen der zweiten Stromschiene und der ersten Stromschiene definieren; und
die erste Leistungshalbleitervorrichtung, das erste Gehäuse und die eine oder die mehreren zweiten Leistungshalbleitervorrichtungen an der ersten Oberseite der ersten Stromschiene angebracht sind.

9. Stromversorgungssystem nach Anspruch 8, wobei die erste Leistungshalbleitervorrichtung und die eine oder die mehreren zweiten Leistungshalbleitervorrichtungen mittels entsprechenden Befestigungselementen an der ersten Stromschiene angebracht sind, wobei Abschnitte der Befestigungselemente sich über die untere Fläche der ersten Stromschiene hinaus in den Abstand erstrecken, welcher zwischen der zweiten Stromschiene und der ersten Stromschiene definiert ist.

10. Stromversorgungssystem nach einem der vorstehenden Ansprüche, wobei das erste Gehäuse, der erste Auslass und eine obere Fläche der ersten Stromschiene, an die die erste Leistungshalbleitervorrichtung gekoppelt ist, gemeinsam einen Kanal definieren, welcher sich von der ersten Leistungshalbleitervorrichtung aus dem Gehäuse hinaus erstreckt, um das Fehlermaterial von der ersten Leistungshalbleitervorrichtung aus dem Gehäuse hinaus und weg von der einen oder den mehreren zweiten Leistungshalbleitervorrichtungen zu leiten.

11. Fahrzeug, umfassend:
eine Fahrzeugplattform;
ein an der Plattform angebrachtes Triebwerk;
einen an dem Triebwerk angebrachten Wechselstromgenerator, wobei der Wechselstromgenerator konfiguriert ist, Elektrizität zu erzeugen, wenn er von dem Triebwerk mechanisch angetrieben wird;
einen an der Fahrzeugplattform angebrachten Motor; und
einen Stromwandler, umfassend das Stromversorgungssystem nach einem der vorstehenden Ansprüche, wobei der Stromwandler konfiguriert ist, die Elektrizität umzuwandeln, um den Motor anzutreiben.

## Revendications

1. Système de distribution d'énergie **caractérisé en ce qu'**il comprend :
une première barre omnibus (306, 502, 702) ;
un premier dispositif d'énergie semi-conducteur (504, 704) couplé à la première barre omnibus ;
un ou plusieurs seconds dispositifs d'énergie semi-conducteurs (306, 506, 706) couplés à la première barre omnibus ; et
un premier logement (304, 508, 512, 706) couplé à la première barre omnibus, dans lequel le premier dispositif d'énergie semi-conducteur est enfermé à l'intérieur du premier logement ;
dans lequel le premier logement comprend une première sortie (510, 514, 744) configurée pour diriger un matériau défaillant du premier dispositif d'énergie semi-conducteur à l'écart des un ou plusieurs seconds dispositifs d'énergie semi-conducteurs ;
dans lequel la première barre omnibus fonctionne en combinaison avec la première sortie dans le premier logement pour acheminer le matériau défaillant dans une direction particulière qui est à l'écart des un ou plusieurs seconds dispositifs d'énergie semi-conducteurs.

2. Système de distribution d'énergie selon la revendication 1, dans lequel le premier dispositif d'énergie semi-conducteur comprend un transistor bipolaire à grille isolée.

3. Système de distribution d'énergie selon la revendication 1 ou la revendication 2, dans lequel les un ou plusieurs seconds dispositifs d'énergie semi-conducteurs (306, 506, 706) sont enfermés à l'intérieur du premier logement (304, 508, 512, 706).

4. Système de distribution d'énergie selon l'une quelconque des revendications 1 à 3, comprenant en outre un ou plusieurs seconds logements (512) couplés à la première barre omnibus, dans lequel les un ou plusieurs seconds dispositifs d'énergie semi-conducteurs sont logés dans les un ou plusieurs seconds logements.

5. Système de distribution d'énergie selon la revendication 4, comprenant une pluralité des seconds dispositifs d'énergie semi-conducteurs et une pluralité des seconds logements, dans lequel les seconds dispositifs d'énergie semi-conducteurs sont respectivement logés individuellement dans les seconds logements.

6. Système de distribution d'énergie selon la revendication 4 ou la revendication 5, dans lequel les un ou plusieurs seconds logements comprennent une seconde sortie respective configurée pour diriger le matériau défaillant à l'écart du premier dispositif d'énergie semi-conducteur et à l'écart d'autres des un ou plusieurs seconds logements.

7. Système selon l'une quelconque des revendications précédentes, dans lequel le premier logement et les un ou plusieurs seconds logements comprennent un matériau de polyester renforcé de fibres de verre.

8. Système de distribution d'énergie selon l'une quelconque des revendications précédentes, dans lequel :
la première barre omnibus comprend un premier palier plan ayant un premier côté supérieur plat et un premier côté inférieur plat opposé au premier côté supérieur, une partie de colonne montante attachée à un premier bord de la partie de colonne montante au premier palier plan et inclinée à un angle de degré non nul par rapport au premier palier plan, et un second palier plan ayant un second côté supérieur plat et un second côté inférieur plat opposé au second côté supérieur, le second palier plan étant attaché à un second bord de la partie de colonne montante, au second bord parallèle au premier bord et au second palier plan incliné à l'angle de degré non nul de telle sorte que le second palier plan est parallèle au premier palier plan ;
le système de distribution d'énergie comprend en outre un une seconde barre omnibus attachée au second côté inférieur du second palier plan de la première barre omnibus et parallèle au premier palier plan, dans lequel une surface supérieure de la seconde barre omnibus et le premier côté inférieur de la première barre omnibus définissent un espace entre la seconde barre omnibus et la première barre omnibus ; et
le premier dispositif d'énergie semi-conducteur, le premier logement et les un ou plusieurs seconds dispositifs d'énergie semi-conducteurs sont attachés au premier côté supérieur de la première barre omnibus.

9. Système de distribution d'énergie selon la revendication 8, dans lequel le premier dispositif d'énergie semi-conducteur et les un ou plusieurs seconds dispositifs d'énergie semi-conducteurs sont attachés à la première barre omnibus par des fixations respectives, dans lequel des parties des fixations s'étendent au-delà de la surface inférieure de la première barre omnibus dans l'espace qui est défini entre la seconde barre omnibus et la première barre omnibus.

10. Système de distribution d'énergie selon l'une quelconque des revendications précédentes, dans lequel le premier logement, la première sortie et une surface supérieure de la première barre omnibus à laquelle est couplé le premier dispositif d'énergie semi-conducteur définissent conjointement un canal s'étendant du premier dispositif d'énergie semi-conducteur à l'extérieur du logement, pour acheminer le matériau défaillant du premier dispositif d'énergie semi-conducteur à l'extérieur du logement et à l'écart des un ou plusieurs seconds dispositifs d'énergie semi-conducteurs.

11. Véhicule comprenant :
une plate-forme de véhicule ;
un moteur attaché à la plate-forme ;
un alternateur attaché au moteur, l'alternateur étant configuré pour générer de l'électricité lorsqu'il est entraîné mécaniquement par le moteur ;
un moteur électrique attaché à la plate-forme de véhicule ; et
un convertisseur d'énergie comprenant le système de distribution d'énergie selon l'une quelconque des revendications précédentes, dans lequel le convertisseur d'énergie est configuré pour convertir l'électricité pour alimenter le moteur électrique.
